Europäisches Patentamt

(19) European Patent Office        (11) Publication number: **0 027 536**

Office européen des brevets                                **B1**

(12)        **EUROPEAN PATENT SPECIFICATION**

(45) Date of publication of patent specification: **20.02.85**        (51) Int. Cl.⁴: **G 03 F 7/16**

(21) Application number: **80105418.0**

(22) Date of filing: **10.09.80**

(54) Coating method and apparatus.

(30) Priority: **18.10.79 US 85844**

(43) Date of publication of application:
**29.04.81 Bulletin 81/17**

(45) Publication of the grant of the patent:
**20.02.85 Bulletin 85/08**

(84) Designated Contracting States:
**CH DE FR GB IT LI NL**

(56) References cited:

**IBM TECHNICAL DISCLOSURE BULLETIN, vol.
19, no. 6, November 1976, New York, US
HOCHBERG et al. "Depositing photoresist in
thin layers independent of surface area", pages
2239-2240**

**IBM TECHNICAL DISCLOSURE BULLETIN, vol.
13, no. 7, December 1970 New York, US C.A.
CORTELLINO et al. "Stress free photoresist
films", page 1887**

(73) Proprietor: **THE PERKIN-ELMER CORPORATION
Main Avenue
Norwalk Connecticut 06432 (US)**

(72) Inventor: **Ausschnitt, Christopher Perry
893 Sasco Hill Road
Southport Connecticut 06490 (US)**
Inventor: **Huchital, David A.
214 Inwood Road
Fairfield Connecticut 06430 (US)**

(74) Representative: **Patentanwälte Dipl.-Ing. A.
Grünecker, Dr.-Ing. H. Kinkeldey, Dr.-Ing. W.
Stockmair,
Dr. rer. nat. K. Schumann, Dipl.-Ing. P.H. Jakob,
Dr. rer. nat. G. Bezold Maximilianstrasse 58
D-8000 München 22 (DE)**

Courier Press, Leamington Spa, England.

## Description

This invention relates to a method and an apparatus for coating the surface of an object with a material, said apparatus comprising a first chamber containing the object to be coated, a second chamber communicating with said first chamber and containing the liquid coating material, first means associated with said second chamber for forming a mist of said coating material within said second chamber, second means for directing said mist to said first chamber and third means associated with said first chamber increasing the rate of settling of the mist onto the object.

Such an apparatus is known from "IBM Technical Disclosure Bulletin" Vol. 19, No. 6, November 1976, pages 2239 to 2240. According to this known apparatus a photoresist is broken up into small particles with the aid of an ultrasonic nebulizer, the higher the ultrasonic frequency the smaller the particle size.

The surface of the object to be coated is statically charged, attracting the nebulized photoresist. The thickness deposited is a function of the time exposed to the mist as well as of the attraction of the photoresist to the object. Depending on the frequency of the ultrasonic nebulizer the particle size of the nebulized photoresist can be adjusted and maintained within a desired range, wherein the mist is then picked up by an air flow and sent past a series of baffles. Particles with too large a character and hence, mass will not follow the air streams around the baffles, but, due to their inertia, will collide with the baffles and can then be collected. Repeating the procedure with several baffles decreases the spread of particle size as well as filters out the foreign matter.

In the fabrication of micro circuits a photoresist coated silicon wafer is exposed to ultra-violet light through a mask containing the circuit patterns to be formed on the wafer. The photoresist is developed or otherwise partially removed leaving the circuit pattern outlined on the wafer. During actual buildup of a complete circuit on the wafer, the wafer may have to be repeatedly coated with the photoresist material. The mask and, therefore, the wafer has a plurality of identical circuits arranged in rows and columns and once the process is completed the wafer is cut into rows and columns to form individual circuits.

A critical part of the foregoing described process is in the provision of silicon wafers coated with the light sensitive photoresist material. As the state of the art in the fabrication of micro circuits advances, it becomes more and more critical that the silicon wafers have a film of photoresist deposited thereon which is highly uniform and lacking defects such as striations.

The technique most widely in use for the coating of silicon wafers with photoresist is known as spinning. This method entails placing a drop of liquid photoresist material on a wafer which is spun. Due to the aerodynamic and centrifugal forces the photoresist eventually covers the entire wafer in a thin film. This method has the disadvantage of poor uniformity in coating thickness. For example, spin coating causes intrinsic and induced striations which are grooves or channels formed in the surface of the coating.

Intrinsic striations are caused by the nature of spin coating itself due to the outward radial movement of the liquid photoresist.

Induced striations are due to specks such as dust or foreign matter in the photoresist or on the wafer, as well as previously etched patterns on a wafer.

These striations, which are areas of differing thickness of the photoresist layer, result in varying degrees of exposure sensitivity which lead to unreliable photoresist development such as removing too little or too much photoresist during developement. This ultimately results in unreliable or failed circuit elements in the finished micro circuits.

Another disadvantage of the spin method of coating is that it is wasteful of the photoresist, with losses typically exceeding 99% of the material.

It is therefore an object of the present invention to improve the method and apparatus as defined by way of introduction so as to significantly shorten the settling time of the mist which is allowed to settle onto the object, thereby providing a uniform thin coating thereon.

For solving this object the invention starts out from a method of coating a surface with a coating material comprising the steps of generating a mist of the liquid coating material, transporting the mist to a volume over the surface to be coated, holding the mist within the volume until the mist settles onto the surface by force of gravity, and increasing the settling rate of the mist droplets after the mist is transported to the volume.

The inventive method is characterized in that the settling rate is increased by producing audio frequency acoustic waves within the volume at a resonant frequency of the volume.

The apparatus for carrying through this method is characterized in that the third means associated with the first chamber comprises acoustic wave generating means for providing audio frequency acoustic waves within said first chamber at a resonant frequency of said first chamber.

In addition to significantly shorten the settling time there are also provided highly uniform, striation-free coatings and furthermore during the coating process the loss of photoresist is greatly reduced. Nebulization also ensures that the mist is made up of droplets of uniform size which is an advantage over spray coating techniques.

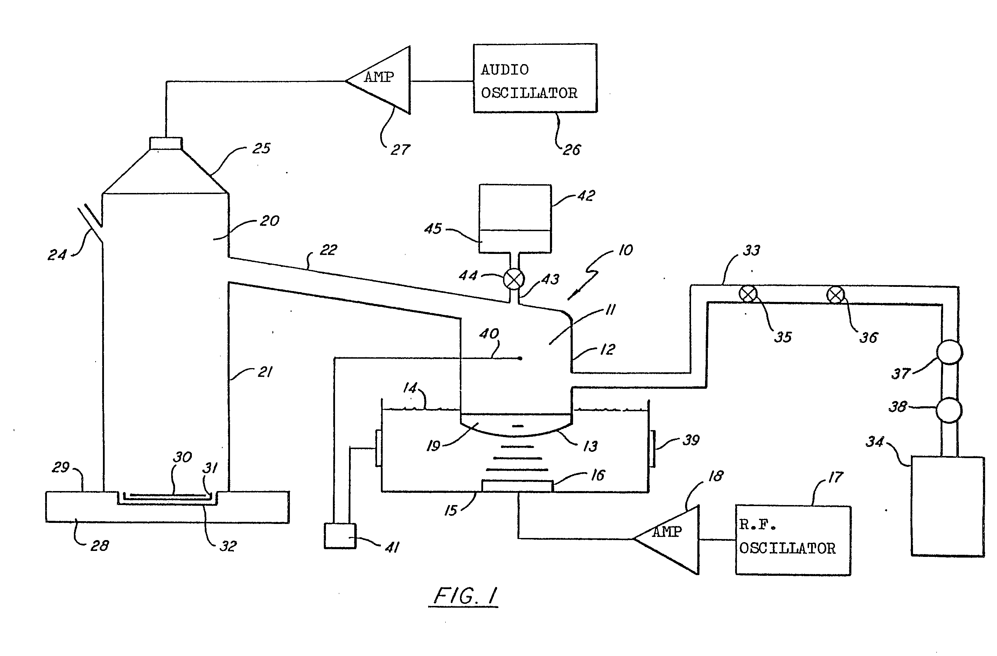

Fig. 1 illustrates in schematic form a preferred embodiment of the present invention.

Referring now more particularly to fig. 1 there is shown the coating apparatus of the present invention. The coating apparatus of the present invention comprises a nebulizer 10 which includes a chamber 11 formed by cylinder 12.

Attached to the bottom of the cylinder 12 forming one end thereof is a flexible membrane or diaphragm 13. The diaphragm 13 may be made of any sound transmissive material such as flexible plastic or mylar. The diaphragm 13 and a portion of the end of the cylinder 12 are immersed in a liquid 14 held in tank 15. A transducer 16 is disposed at the bottom of the tank 15 directly beneath the diaphragm 13. An oscillator 17 is connected to the transducer 16 via an amplifier 18. The chamber 11 has at its bottom end a quantity of liquid photoresist 19 deposited therein. The upper surface of the photoresist 19 is maintained below the surface of the liquid 14.

The upper end of the chamber 11 is connected to chamber 20 through conduit 22.

The chamber 20 comprises a cylinder 21 which is significantly longer than the chamber cylinder 12. The conduit 22 is angled upwardly so that it communicates with the chamber 20 near the upper end of the cylinder 21. Use of an angled conduit 22 permits photoresist on the walls of conduit 22 to fall back into chamber 11 for reuse. The chamber 20 is vented to atmosphere by means of the vent tube 24. A transducer 25 which may be a speaker is disposed at the top end of the cylinder 21. Transducer 25 is circular in cross-section having a diameter substantially the same as the diameter of cylinder 21 and forms an air tight closure for the upper end of the cylinder 21. Transducer 25 is connected to audio oscillator 26 through amplifier 27. The cylinder 21 is supported by base 28 which forms an air tight seal with the bottom end of the cylinder 21 at surface 29 of the base 28.

A wafer 30 is disposed at the bottom of the chamber 20. The wafer is held by carrier 31 which is slidable perpendicular to the plane of the drawing within the recess 32 formed in the base 28. In this way the wafer 30 may be easily inserted into and removed from the chamber 20. If desired, the carrier 31 may be dimensioned to hold more than one wafer to permit removal of a coated wafer while another is being coated.

A conduit 33 has one end connected to the chamber 11 near the bottom end of the cylinder 12. The other end of the conduit 33 is connected to a pressurized source of gas 34 through toggle valve 35, flow valve 36, flowmeter 37, and regulator 38.

The apparatus is designed so that a mist of a liquid photoresist which is created within chamber 11 is transported to chamber 20 where it is allowed to settle onto the surface of wafer 30.

The formation of a mist within a chamber 11 is accomplished by a process known as nebulization. In this process a liquid such as the liquid photoresist 19 is converted to a mist or aerosol by means of ultrasonic waves produced by the transducer 16 and transmitted through liquid 14 to the photoresist 19 through the diaphragm 13. The transducer 16 is energized by oscillator 17 via the amplifier 18. During the initial mist formation the chamber 11 is isolated from the pressurized gas from gas tank 34 by means of toggle valve 35 being in the closed position.

During generation of the mist within the chamber 11 the transducer 16 is driven at its mechanical resonance which in one practical example is 1.25 megahertz by means of RF oscillator 17 and power amplifier 18. The ultrasonic waves are transmitted through the liquid 14. The ultrasonic waves pass through the liquid photoresist 19. The mist or aerosol is formed at the surface of the photoresist.

The liquid 14 is used to transfer the ultrasonic energy from the transducer 16 to the photoresist 19. Water is a good medium for the transfer. If a liquid were not used, the transducer 16 would have to be placed closely adjacent or contiguous with the diaphragm 13 which might erode the transducer 16 or cause excessive wear on the diaphragm 13. Additionally, the liquid 14 provides a thermal mask which permits the liquid 14 to be maintained at a predetermined temperature which because of its mass does not respond to rapid changes in ambient temperatures. Further, the liquid 14 maintains the liquid photoresist which is immersed therein at a stable constant temperature.

The temperature of the liquid 14 and therefore the mist may be maintained by a heater 39 wrapped around the tank 15 and controlled by a thermocouple 40 for switching a source of power 41 to the heating tape when the temperature falls below a desired value.

In a practical embodiment for a photoresist of a given viscosity, e.g. Shipley 1350B, it has been found desirable to maintain the mist created within the chamber 11 at 68,33°C Since deposition times and coating thickness may vary with mist temperature depending on the viscosity of the photoresist 19 plus other variables, it is important for reproducibility considerations that mist temperature be maintained constant. It has been found that acceptable coating of a liquid photoresist such as Shipley 1350B photoresist may be obtained by maintaining the mist between 54,44° and 87,8°C. Also acceptable coatings are obtained when power at which transducer is driven is within 10 to 40 watts. As aforesaid, the temperature and drive power conditions apply to 1350B Shipley photoresist. Conditions will vary depending upon the particular photoresist used.

Once a sufficient amount of mist is generated within the chamber 11 it is caused to be transferred into chamber 20 via conduit 22. The mist within the chamber 20 is then allowed to settle by precipitation onto the exposed surfaces of the wafer 30. A refill chamber 42 containing liquid photoresist 45 is connected to chamber 11 via tube 43 and valve 44 for the purpose of adding photoresist to chamber 11 to compensate for loss after a predetermined number of coatings. The concentration (resin : solvent) of the photoresist added to chamber 11 to compensate for the losses is lower than the concentration of the photoresist in chamber 11. This is due to the fact that the loss of solvent is greater than the loss of resin for each coating.

In a practical embodiment for Shipley 1350B photoresist it has been found that the concentration in the refill chamber should be between 1:2 and 1:3, where concentration is defined as the ratio of 1350B photoresist to the solvent AZ thinner.

It has been discovered by applicant that by causing an acoustic resonance within the chamber 20 the settling rate of the mist onto the wafer 30 is significantly increased.

Acoustic resonance is provided by means of acoustic transducer 25 powered by oscillator 26 via amplifier 27 at a frequency equal to the resonant acoustic frequency of the chamber 20 at a relatively low power, for example, 1 to 5 watts.

In a practical embodiment it has been found that a coating of one micron thickness of photoresist on the wafer 30 without acoustic resonance takes between one and two minutes whereas with acoustic resonance the settling time is reduced to 15 seconds. The specific frequency used in 310Hz, the fundamental acoustic resonance of chamber 20. The next resonance at 620 Hz is equally effective, but is more irritating to the human ear. Higher frequency resonances are less effective due to their decreasing Q.

The manner in which the mist is transferred from chamber 11 to chamber 20 is described hereinbelow.

As aforesaid during the initial mist formation, the chamber 11 is isolated from the pressurized source of inert gas 34 by the toggle valve 35. On the other side of flow valve 36 gas pressure is at a higher pressure than atmosphere established by the gas regulator 38. Flow regulator 38 is adjusted so that the gas flow after the toggle valve 35 and flow valve 36 are opened reaches a flow steady state value.

When the temperature in the chamber 11 reaches the desired value, for example 68,33°C as measured by a thermocouple 40 which indicates that sufficient thermocouple mist has formed, toggle valve 35 is opened. The high gas pressure existing in the conduit 33 between the toggle valve 35 and the flow valve 36 causes an initial rush of gas into the photoresist chamber via conduit 33. This initial rush pushes the mist from chamber 11 through the conduit 22 into the chamber 20. This displaces the air within the chamber 20 which escapes through vent 24. The mist then settles onto the wafer 30. As aforesaid settling time is decreased by use of speaker 25 causing acoustic resonance within the chamber 20.

It should be noted that wafer 30 may be introduced into chamber 20 after transfer of the mist thereto as well as before the mist is transferred to chamber 20.

When the mist is in the chamber 20, the flutter valve 23 may be closed along with valves 35 and 36 to permit formation of more mist in the chamber 11 for coating the next wafer.

When the wafer 30 is coated, the carrier 31 may be slid out and the wafer 30 removed and replaced with a new wafer to be coated. As aforesaid the carrier 31 may be elongated or long enough to hold two or more wafers so that when wafer 30 is removed another wafer is automatically placed in position for coating.

Alternatively, the process may be automated with carrier 31 in effect forming a conveyor which is automatically moved to place a next wafer within the chamber 20 after the preceding wafer is coated. Also, the entire process may be automated by timing techniques for turning on power to the transducer 16, speaker 25 and opening and closing valves 35 and 36 all based on time requirements for coating a wafer to a desired coating thickness.

It should be noted that means other than that shown may be used for transferring a mist from chamber 11 to chamber 20. For example, a bellows arrangement may be used for puffing the mist into the chamber 20. The bellows could use any convenient gas, such as air.

Also, it should be noted that the average cost in photoresist material for coating a 10,16 cm wafer to one micron thickness using the present invention is one cent as opposed to an average cost of fourteen cents for the spinning method.

Other modifications of the present invention are possible in light of the above specification which should not be deemed as limiting the invention beyond those limitations placed in the claims which follow.

**Claims**

1. An apparatus for coating the surface of an object (30) with a material, comprising a first chamber (20) containing the object to be coated, a second chamber (11) communicating with said first chamber and containing the liquid coating material (19), first means (16) associated with said second chamber for forming a mist of said coating material within said second chamber, second means (34) for directing said mist to said first chamber and third means (25) associated with said first chamber increasing the rate of settling of the mist onto the object, characterized in that the third means (25) comprise acoustic wave generating means for providing audio frequency acoustic waves within said first chamber (20) at a resonant frequency of said first chamber.

2. An apparatus according to claim 1, characterized in that said first means (16) comprises transducer means for transmitting ultrasonic waves into said coating material (19).

3. An apparatus according to claim 2, characterized in that said second chamber (11) comprises a diaphragm (13) closing one end of said second chamber, said one end of said second chamber containing the coating material positioned above said transducer means.

4. An apparatus according to claim 3, characterized in that said first means (16) further comprises a tank (15) containing a liquid (14), said one end of said second chamber (11) imersing in said liquid, and said transducer means (16) disposed within said tank directly beneath said diaphragm (13).

5. An apparatus according to any one of the claims 1—4, characterized in that said acoustic wave generating means (25) comprises acoustic transducer disposed at one end of said first chamber (20) and audio oscillator means (26) connected to said transducer.

6. An apparatus according to claim 5, characterized in that base means (28) are provided closing the other end of said first chamber (20) supporting the object (30) to be coated within the chamber.

7. An apparatus according to claim 6, characterized in that said base means (28) comprises a base supporting said first chamber (20), and carrier means (31) disposed within a recess formed in said base and moveable relative to said base.

8. An apparatus according to any one of the claims 1—7, characterized in that said second means comprises fourth means (34) providing a gas flow, a first conduit (33) connecting said fourth means (34) to said second chamber (11) near said one end such that said mist is carried from said second chamber (11) to said first chamber (20), and a valve (35, 36) in said first conduit for opening and closing said first conduit.

9. An apparatus according to claim 8, characterized in that said fourth means (34) for providing a gas flow comprises a source of pressurized gas and a regulator valve (37, 38) for controlling the rate of gas flow through said first conduit (33).

10. An apparatus according to any one of claims 1—9, characterized in that the other end of said second chambers (11) is connected via a second conduit (22) to said first chamber (20) near said one end of said first chamber, said first chamber (20) being substantially longer than said second chamber (11), and said second conduit (22) extending upwardly from said second chamber (11) to said first chamber (20).

11. An apparatus according to any one of the claims 1—10, characterized in that said coating material is a liquid resist and said object (30) to be coated is a silicon wafer.

12. An apparatus according to any one of the claims 1—11, characterized in that the second chamber is connected with fifth means (42) for replenishing said photoresist in said second chamber (11) after a predetermined number of coatings.

13. An apparatus according to any one of the claims 7—12, characterized in that said carrier means (31) is formed to support a plurality of said wafers (30) whereby when one wafer is coated the next wafer to be coated may be moved into position for coating.

14. An apparatus according to any one of the claims characterized in that means (39, 41) are provided for maintaining the temperature of the mist within a predetermined range.

15. An apparatus according to any one of the claims 2—14, characterized in that the transducer means for transmitting ultrasonic waves being driven at a power between ten and forty watts.

16. An apparatus according to any one of the claims 5—15, characterized in that the acoustic transducer (25) comprises a speaker closing one end of said first chamber (20).

17. A method of coating a surface with a coating material comprising the steps of generating a mist of the liquid coating material, transporting the mist to a volume over the surface to be coated, holding the mist within the volume until the mist settles onto the surface by force of gravity, and increasing the settling rate of the mist droplets after the mist is transported to the volume, characterized in that the settling rate is increased by producing audio frequency acoustic waves within the volume at a resonant frequency of the volume.

18. A method according to claim 17, characterized in that the mist is produced by ultrasonically nebulizing the material.

## Revendications

1. Appareil servant à revêtir la surface d'un objet (30) avec une matière, comprenant une première chambre (20) contenant l'objet à revêtir, une deuxième chambre (11) communiquant avec la première chambre et contenant la matière liquide de revêtement (19), des premiers moyens (16) associés à la deuxième chambre pour former un brouillard de la matière de revêtement à l'intérieur de la deuxième chambre, des deuxièmes moyens (34) servant à diriger ce brouillard vers la première chambre et des troisièmes moyens (25) associés à la première chambre, augmentant la vitesse de dépôt du brouillard sur l'objet, caractérisé par le fait que les troisièmes moyens (25) comprennent des moyens générateurs d'ondes acoustiques servant à fournir des ondes acoustiques à audiofréquences à l'intérieur de la première chambre (20), à une fréquence de résonance de cette première chambre.

2. Appareil selon la revendication 1, caractérisé par le fait que les premiers moyens (16) comprennent des moyens à tranducteur servant à transmettre des ondes ultrasoniques à la matière de revêtement.

3. Appareil selon la revendication 2, caractérisé en ce que la deuxième chambre (11) comprend un diaphragme (13) fermant une extrémité de la deuxième chambre, cette extrémité de la deuxième chambre contenant la matière de revêtement placée au-dessus des moyens à transducteur.

4. Appareil selon la revendication 3, caractérisé en ce que les premiers moyens (16) comprennent en outre une cuve (15) contenant un liquide (14), l'extrèmité mentionée de la deuxième chambre (11) étant plongée dans un liquide, et les moyens à transducteur (16) étant disposés à l'intérieur de la cuve, directement en dessous du diaphragme (13).

5. Appareil selon l'une quelconque des revendications 1 à 4, caractérisé par le fait que les moyens générateurs d'ondes acoustiques (25) comprennent un transducteur acoustique disposé à une extrémité de la première chambre (20) et des moyens à oscillateur à audiofréquence (26) reliés à ce transducteur.

6. Appareil selon la revendication 5, caractérisé par le fait que des moyens de base sont prévus, fermant l'autre extrémité de la première chambre (20) et supportant l'objet (30) à revêtir à l'intérieur de la chambre.

7. Appareil selon la revendication 6, caractérisé par le fait que les moyens de base (28) comprennent une base supportant la première chambre (20) et des moyens supports (31) disposès à l'intérieur d'un évidement formé dans la base et mobiles relativement à cette base.

8. Appareil selon l'une quelconque des revendications 1 à 7, caractérisé par le fait que les deuxièmes moyens comprennent des quatrièmes moyens (34) fournissant un courant de gaz, un premier conduit (33) reliant les quatrièmes moyens (34) à la deuxième chambre (11) près de la première extrémité mentionnée, de sorte que ce brouillard est transporté de la deuxième chambre (11) à la première chambre (20), et un valve (35, 36) prévue dans le premier conduit pour ouvrir et fermer le premier conduit.

9. Appareil selon la revendication 8, caractérisé par le fait que les quatrième moyens (34) servant à fournir un courant de gaz comprennent une source de gaz sous pression et une valve régulatrice (37, 38) servant à régler le débit d'écoulement du gaz par le premier conduit (33).

10. Appareil selon l'une quelconque des revendications 1 à 9, caractérisé par le fait que l'autre extrémité de la deuxième chambre (11) est reliée, par un deuxième conduit (22), à la première chambre (20), près de la première extrémité mentionnée de la première chambre, la première chambre (20) étant notablement plus longue que la deuxième chambre (11) et le deuxième conduit se dirigeant vers le haut, de la deuxième chambre (11) à la première chambre (20).

11. Appareil selon l'une quelconque des revendications 1 à 10, caractérisé par le fait que la matière de revêtement est une photoréserve liquide et que l'objet (30) à revêtir est une pastille de silicium.

12. Appareil selon l'une quelconque des revendications 1 à 11, caractérisé par le fait que la deuxième chambre est reliée à des cinquièmes moyens (42) servant à replacer la photoréserve dans la deuxième chambre (11) au bout d'un nombre prédéterminé de revêtements.

13. Appareil selon l'une quelconque des revendications 7 à 12, caractérisé par le fait que les moyens supports sont constitués de manière à supporter plusieurs des pastilles (30), de sorte que lorsqu'une pastille est revêtue, la pastille suivante à revêtir peut être amenée en position pour le revêtement.

14. Appareil selon l'une quelconque des revendications, caractérisé par le fait que les moyens (39, 41) sont prévus pour maintenir la température de brouillard dans un intervalle prédéter-. miné.

15. Appareil selon l'une quelconque des revendications 2 à 14, caractérisé par le fait que les moyens à transducteur servant à transmettre des ondes ultrasoniques sont excités à une puissance comprise entre 10 et 40 W.

16. Appareil selon l'une quelconque des revendications 5 à 15, caractérisé par le fait que le transducteur acoustique (25) comprend un haut-parleur fermant une extrémité de la première chambre (20).

17. Procédé pour revêtir une surface avec une matière de revêtement, comprenant les étapes consistant à engendrer un brouillard de la matière liquide de revêtement, à transporter le brouillard jusqu'à un volume situé au-dessus de la surface à revêtir, à maintenir le brouillard à l'intérieur du volume jusqu'à ce que le brouillard se dépose sur la surface par la force de gravité, et à augmenter le vitesse de dépôt des gouttelettes de brouillard une fois que le brouillard a été transporté jusqu'au volume, caractérisé par le fait que l'on augmente la vitesse de dépôt en engendrant des ondes acoustiques à audiofréquence à l'intérieur du volume, à une fréquence de résonance du volume.

18. Procédé selon la revendication 17, caractérisé par le fait que l'on forme le brouillard en nébulisant la matière par ultrasons.

**Patentansprüche**

1. Apparat zum Beschichten der Oberfläche eine Gegenstandes (30) mit einem Material, mit einer ersten, den zu beschichtenden Gegenstand enthaltenden Kammer (20), einer zweiten Kammer (11), die mit der ersten Kammer in Verbindung steht und das flüssige Beschichtungsmaterial (19) enthält, einer ersten Einrichtung (16), die mit der zweiten Kammer verbunden ist, um einen Nebel aus dem Beschichtungsmaterial innerhalb der zweiten Kammer zu bilden, einer zweiten Einrichtung (34), um den Nebel zu der ersten Kammer zu lenken, und einer dritten Einrichtung (25), die mit der ersten Kammer verbunden ist und die Niederschlagsgeschwindigkeit des Nebels auf den Gegenstand erhöht, dadurch gekennzeichnet, daß die dritte Einrichtung (25) ein Schallwellen-Erzeugungseinrichtung umfaßt, um Tonfrequenz-Schallwellen innerhalb der ersten Kammer (20) bei der Resonanzfrequenz der ersten Kammer hervorzurufen.

2. Apparat nach Anspruch 1, dadurch gekennzeichnet, daß die erste Einrichtung (16) eine Wandlereinrichtung umfaßt, um Ultraschallwellen in das Beschichtungsmaterial (19) zu übertragen.

3. Apparat nach Anspruch 2, dadurch gekennzeichnet, daß die zweite Kammer (11) eine Membran (13) umfaßt, die ein Ende der zweiten Kammer verschließt, wobei das eine Ende der zweiten Kammer das Beschichtungsmaterial enthält, welches oberhalb der Wandlereinrichtung positioniert ist.

4. Apparat nach Anspruch 3, dadurch gekennzeichnet, daß die erste Einrichtung (16) ferner einen eine Flussigkeit (14) enthaltenden Behälter (15) umfaßt, wobei das eine Ende der zweiten Kammer (11) in die Flüssigkeit eingetaucht ist, und die Wandlereinrichtung (16) innerhalb des Behälters unmittelbar unterhalb der Membran (13) angeordnet ist.

5. Apparat nach einem der Ansprüche 1—4, dadurch gekennzeichnet, daß die Schallenwellen-Erzeugungseinrichtung (25) einen Schallwandler, der an einem Ende der ersten Kammer (20) angeordnet ist, und eine Tonfrequenz-Oszillatoreinrichtung (26) umfaßt, die mit dem Wandler verbunden ist.

6. Apparat nach Anspruch 5, dadurch gekennzeichnet, daß eine Basiseinrichtung (28) vorgesehen ist, die das andere Ende der ersten Kammer (20) schließt und den zu beschichtenden Gegenstand (30) innerhalb der Kammer abstützt.

7. Apparat nach Anspruch 6, dadurch gekennzeichnet, daß die Basiseinrichtung (28) eine die erste Kammer (20) anstützende Basis und eine Trageinrichtung (31) umfaßt, die in einer Ausnahmung angeordnet ist, welche in der Basis gebildet ist und relativ zu der Basis bewegbar ist.

8. Apparat nach einem der Ansprüche 1—7, dadurch gekennzeichnet, daß die zweite Einrichtung umfaßt eine vierte Einrichtung (34) zum Herstellen einer Gasströmung, eine erste Leitung (33), die die vierte Einrichtung (34) mit der zweiten Kammer (11) nahe dem einen Ende derart verbindet, daß der Nebel von der zweiten Kammer (11) zu der ersten Kammer (20) getragen wird, und ein Ventil (35, 36) in der ersten Leitung zum Öffnen und Schließen der ersten Leitung.

9. Apparat nach Anspruch 8, dadurch gekennzeichnet, daß die vierte Einrichtung (34) zum Herstellen einer Gasströmung eine Druckgasquelle und eine Regulierventil (37, 38) zum Steuern der Gasströmungsgeschwindigkeit durch die erste Leitung (33) umfaßt.

10. Apparat nach einem der Ansprüche 1—9, dadurch gekennzeichnet, daß das andere Ende der zweiten Kammer (11) über eine zweite Leitung (22) mit der ersten Kammer (20) nahe dem einen Ende der ersten Kammer verbunden ist, wobei die erste Kammer (20) im wesentlichen länger als die zweite Kammer (11) ist, und daß sich die zweite Leitung (22) von der zweiten Kammer (11) nach oben zu der ersten Kammer (20) erstreckt.

11. Apparat nach einem der Ansprüche 1—10, dadurch gekennzeichnet, daß das Beschichtungsmaterial ein flüssiger Photoresist und der zu beschichtende Gegenstand (30) ein Siliziumplättchen ist.

12. Apparat nach einem der Ansprüche 1—11, dadurch gekennzeichnet, daß die zweite Kammer mit einer fünften Einrichtung (42) verbunden ist, um den Photoresist in der zweiten Kammer (11) nach einer vorbestimmten Anzahl von Beschichtungen nachzufüllen.

13. Apparat nach einem der Ansprüche 7—12, dadurch gekennzeichnet, daß die Trageinrichtung (31) ausgebildet ist, eine Vielzahl von Plättchen (30) zu stützen, wobei, wenn ein Plättchen beschichtet worden ist, das nächste zu beschichtende Plättchen in die Beschichtungsposition bewegt werden kann.

14. Apparat nach einem der vorgehenden Ansprüche, dadurch gekennzeichnet, daß eine Einrichtung (39, 41) vorgesehen ist, um die Temperatur des Nebels innerhalb eines vorbestimmten Bereiches aufrecht zu halten.

15. Apparat nach einem der Ansprüche 2—14, dadurch gekennzeichnet, daß die Wandlereinrichtung zum Übertragen von Ultraschallwellen mit einer Leistung zwischen 10 und 40 Watt betrieben wird.

16. Apparat nach einem der Ansprüche 5 —15, dadurch gekennzeichnet, daß der Schallwandler (25) einen Lautsprecher umfaßt, der ein Ende der ersten Kammer (20) schließt.

17. Verfahren zum Beschichten einer Oberfläche mit einem Beschichtungsmaterial, bei dem eine Nebel aus dem flüssigen Beschichtungsmaterial erzeugt wird, der Nebel zu einem Volumen oberhalb der zu beschichtenden Oberfläche transportiert wird, der Nebel innerhalb des Volumens gehalten wird, bis sich der Nebel auf die Oberfläche aufgrund der Schwerkraft niederschlägt, und die Niederschlagsgeschwindigkeit der Nebeltröpfchen erhöht wird, nachdem der Nebel zu dem Volumen transportiert worden ist, dadurch gekennzeichnet, daß die Niederschlagsgeschwindigkeit dadurch erhöht wird, daß Tonfrequenz-Schallwellen innerhalb des Volumens bei einer Resonanzfrequenz des volumens erzeugt werden.

18. Verfahren nach Anspruch 17, dadurch gekennzeichnet, daß der Nebel dadurch erzeugt wird, daß das Material durch Ultraschall in Nebel übergeführt wird.

FIG. 1

AUDIO OSCILLATOR

AMP

R.F. OSCILLATOR

AMP

0027 536